# EUROPEAN PATENT SPECIFICATION

(11) **EP 3 679 167 B1**
(45) Date of publication and mention of the grant of the patent: **16.06.2021**
(21) Application number: 19795239.3
(22) Date of filing: 05.11.2019
(51) Int. Cl.: C22C 19/03, C23C 18/50, H01L 21/288, H01L 23/00

(54) **ELECTROLESS NICKEL PLATING SOLUTION**
ELEKTROLOSE VERNICKELUNGSLÖSUNG
SOLUTION DE PLACAGE DE NICKEL CHIMIQUE

(30) Priority: 06.11.2018 EP 18204563
(43) Date of publication of application: 15.07.2020
(73) Proprietor: Atotech Deutschland GmbH, 10553 Berlin (DE)
(72) Inventor: BERA, Holger, 10553 Berlin (DE); SCHWARZ, Christian, 10553 Berlin (DE); Schulze Andreas, Berlin 10553 (DE)
(74) Representative: Atotech Deutschland GmbH
(86) International application number: PCT/EP2019/080239
(87) International publication number: WO 2020/094642

(56) References cited:
- WO-A2-2006/102180
- CN-A- 103 352 213
- KR-A- 20120 108 632
- US-A- 5 628 807

## Description

### FIELD OF THE INVENTION

The present invention relates to an electroless nickel plating solution, a method for electroless plating of a nickel alloy layer on a substrate, a nickel alloy layer obtainable from the plating solution and an article comprising such layer.

### BACKGROUND OF THE INVENTION

Electronic articles, such as semiconductor wafers or semiconductor chips, often comprise a so-called copper redistribution layer (Cu-RDL). A redistribution layer (RDL) is an extra metal layer that makes the input or output pads of an integrated circuit available in other locations. This makes electrical connection of the chip or wafer circuitry to external circuitry possible. Typical layouts for electrical connections are bondable (solderable) connections, e.g. known as ball grid arrays and pads of different geometry. To create a bondable (solderable) surface on the Cu-RDL, a Nickel layer is plated onto it. This layer is formed for housing reasons (avoiding oxidation of Copper and achieving mechanical reinforcement) and to generate a diffusion barrier between the Cu-RDL and bondable (solderable) metal layers deposited thereon. Further metal layers like palladium and optionally gold layers are plated onto the nickel layer in order to obtain a bondable (solderable) surface, thus yielding a stack of layers, also called bondable stack. A soldered connection is made via the palladium or gold layer to other devices. Creating a soldered connection of the electronic article with a substrate, such as a printed circuit board or other circuit carrier, involves thermal load to the stack as it is heated to higher temperature.

Annealing of a nickel layer is done in order to test whether the layer can withstand thermal stress which is applied during a soldering process. After annealing, the nickel layer deposited onto the Cu RDL or a bondable stack and the underlying metallic layer often show delamination and additionally fractures within the layers occur. This is responsible for higher resistance or reduced conductivity or even non-conductivity.

Nickel layers with different compositions are known from the prior art, also in other applications. Electroless nickel palladium gold processes for wire bonding and flip chip soldering are known in the prior art and described, for example, in European patent application EP 0 701 281 A2. Similar processes are described in US patent No. 6,445,069 and European patent application EP 1 126 519 A2.

In the prior art EP 2 177 646 A1 a Cu or Al layer is coated first on the wafer surface, followed by the plating of Ni-P and Pd (and optionally Au). This can be done on individual compartments of the wafer surface ("pads").

WO 2009092706 A2 relates to a solution for the deposition of barrier layers on metal surfaces, which comprises compounds of the elements nickel and molybdenum, at least one first reducing agent selected from among secondary and tertiary cyclic aminoboranes and at least one complexing agent, where the solution has a pH of from 8.5 to 12.

WO 2006102180 A2 discloses a nickel alloy layer. For example, the nickel based alloy may be a binary alloy or ternary alloy, such as nickel boride (NiB), nickel phosphide (NiP), nickel tungsten phosphide (NiWP), nickel tungsten boride (NiWB), nickel molybdenum phosphide (NiMoP), nickel molybdenum boride (NiMoB), nickel rhenium phosphide (NiReP), nickel rhenium boride (NiReB).

KR 20120108632 A discloses an electroless bath for the deposition of a nickel alloy layer comprising nickel, molybdenum and tungsten for the fabrication of semiconductor wafers.

### OBJECT OF THE INVENTION

An object of the invention was to create a nickel deposit with reduced stress, particularly reduced tensile stress, and increased fracture toughness after annealing, to prevent delamination from the underlying metal layer, in particular copper or aluminium, and crack formation of the nickel layer.

### SUMMARY OF THE INVENTION

The present invention provides an electroless nickel plating solution, a method for electroless plating, a nickel alloy layer, an article and a use of the plating solution according to the independent claims. Further embodiments are disclosed in dependent claims and this description.

The electroless nickel plating solution of the invention comprises
- a source of nickel ions,
- a source of molybdenum ions,
- a source of tungsten ions,
- a source of hypophosphite ions
- a complexing agent,
- at least one organic sulphur containing compound in a concentration of 0.38 - 38.00 µmol/L,
- at least one amino acid, preferably in a concentration of 0.67 - 40.13 mmol/L,
   werein the solution does not comprise any reducing agent comprising boron.

The method of the invention for electroless plating of a nickel alloy layer on a substrate, particularly a wafer, comprises contacting a substrate with an electroless nickel plating solution of the invention. The substrate is particularly a semiconductor chip or a semiconductor wafer.

The quaternary nickel alloy layer of the invention comprises,
- 67.5 to 98.4 wt% (weight percent), preferably 81.5 to 98.4 wt%, more preferably 88 to 92 wt%, nickel
- 1 to 10 wt%, preferably 4 to 8.5 wt%, molybdenum
- 0.1 to 4 wt%, preferably 0.5 to 2 wt%, tungsten
- 0.5 to 4.5 wt%, preferably 1.5 - 3 wt%, phosphor and is preferably free of other alloying components.

In a preferred embodiment the nickel alloy layer consists of:
- 81.5 to 98.4 wt%, preferably 88 to 92 wt%, nickel,
- 1 to 10 wt%, preferably 4 to 8.5 wt%, molybdenum,
- 0.1 to 4 wt%, preferably 0.5 to 2 wt%, tungsten,
- 0.5 to 4.5 wt%, preferably 1.5 - 3 wt%, phosphor and
- is free of other alloying components.

"Free of" in this context means that the amount of other constituents as e.g. sulphur and lead (Pb) which might be co-deposited from the nickel plating solution is in total 0 to 1 wt%, preferably 0 to 0.5 wt%, more preferably 0. These other constituents will not change the characteristics of the inventive layer in sense of the present invention.

The quantity of all constituents in the nickel layer above adding up to 100 % by weight (wt. %) or with other words the sum of all constituents does not exceed the total of 100 % by weight, also in case further constituents are comprised. If further constituents are comprised, e.g. small amounts of other alloying constituents, the ratio of the wt%-ranges of nickel, molybdenum, tungsten and phosphor to each other will not change and reduced equally to each other.

The nickel alloy layer of the invention is obtainable or obtained from an electroless nickel plating solution of the invention, when the solution is used for plating such layer, or by a method of the invention. The nickel alloy layer of the invention is preferably a crystalline nickel alloy layer.

The article of the invention is particularly an electronic article, particularly a semiconductor chip or a semiconductor wafer. The article comprises a nickel alloy layer of the invention. The article is obtained or obtainable by a method of the invention. The article may comprises a stack of layers, having the order: a copper layer or an aluminium layer followed by the nickel alloy layer and a palladium and/or gold layer, wherein the palladium layer is preferably an outer layer.

A semiconductor chip is a small piece of a semiconductor, typically silicon, crystal which has a plurality of electronic circuits. A semiconductor wafer comprises a plurality of semiconductor chips. It is formed as a slice from a semiconductor crystal ingot which comprises the circuitries of the chips which it carries.

The electroless nickel plating solution of the invention allows the deposition of a quaternary nickel deposit (NiMoWP). The quaternary nickel deposit shows reduced stress, particularly reduces tensile stress, and improved fracture toughness, particularly after annealing, for example at 350-400°C.

The invention may in particular be used for manufacturing of an electronic article having a Cu RDL (re-distribution layer) wherein the nickel deposit is plated onto the Cu-RDL.

More specifically, the invention may be used for manufacturing of an electronic article having a bondable metallic coating stack, wherein the stack is coated onto a copper or aluminium layer. Typical stacks may have the following metal layers Ni/Pd (made by a so-called ENEP process), Ni/Pd/Au (made by a so-called ENEPIG process) or Ni/Au (made by a so-called ENIG process) onto a copper or aluminium layer, wherein Ni is considered as Ni alloy layer according NiMoWP layer. Typically, the stack is formed on a Cu-RDL which is part of the electronic article as is described in the introductory part of this application.

The nickel plating solution of the invention may in particular used for producing a barrier layer between two metal layers, in particular between a copper layer or an aluminium layer and a palladium or a gold layer.

### DETAILED DESCRIPTION OF THE INVENTION

The electroless nickel plating solution of the invention is also called an electroless nickel bath, or electroless nickel plating bath. The term solution does not exclude that one or more components may partially be present in undissolved state.

The nickel alloy layer is also called a quaternary nickel layer or quaternary nickel deposit, the quaternary layer comprising nickel, molybdenum, tungsten and phosphor.

If a layer is in this description is named after a metal, like a "Pd layer" or an "Au layer", this term also encompasses alloys comprising the respective metal as main component, if not otherwise mentioned. Main component means that the component constitutes at least 50 wt%.

Where the term "comprising" is used in the present description and claims, it does not exclude other elements. For the purposes of the present invention, the term "consisting of" is considered to be a preferred embodiment of the term "comprising". If hereinafter a group is defined to comprise at least a certain number of embodiments or features, this is also to be understood to disclose a group which preferably consists only of these embodiments or features.

Where an indefinite or definite article is used when referring to a singular noun, e.g. "a", "an" or "the", this includes a plural of that noun unless something else is specifically stated. The terms "about" or "approximately" in the context of the present invention denotes an interval of accuracy that the person skilled in the art will understand to still ensure the technical effect of the feature in question. The term typically indicates deviation from the indicated numerical value of ±10%, and preferably of ±5%.

The term "at least one" encompasses the special case of "exactly one" or "one".

The concentration ranges given in the description refer to the total amount of all mentioned compounds in sum. With other words, if e.g. two organic sulphur containing compounds are used, the total concentration of all single organic sulphur containing compounds together will not be out the given concentration ranges.

In the following detailed description, aspects and specific embodiments of the invention are shown.

### The plating solution

The plating solution of the invention may be used for deposition of a nickel alloy layer of the invention onto a substrate, particularly on a semiconductor waver or on a chip. Specific articles of the invention are described below. The plating solution of the invention can be used for producing any of these articles. The solution of the invention can particularly be used for producing a barrier layer (diffusion barrier) between two metal layers, for example between a copper layer or an aluminium layer and another metal layer, in order to prevent migration of copper into the other metal. The other metal is for example palladium or gold.

### The source of nickel ions

In an embodiment, the concentration of nickel ions is 0.067 - 0.133 mol/L, preferably 0.084 - 0.116 mol/L.

In a further embodiment, the concentration of nickel ions is 4.0 - 8.0 g/L, preferably 5.0 - 7.0 g/L.

The source of nickel ions may be one or more chemical compounds which comprise nickel and which deliver nickel ions, so that nickel can be incorporated into the NiMoWP layer to be formed. In a specific embodiment, the source of nickel ions is NiSO₄ x 6 H₂O.

When the source of nickel ions is NiSO₄ x 6 H₂O, the concentration of NiSO₄ x 6 H₂O may be 17.53 - 35.05 g/L, preferably 21.91 - 30.69 g/L.

### The source of molybdenum ions

In an embodiment, the concentration of molybdenum ions is 1.05 - 4.18 mmol/L, preferably 1.58 - 3.66 mmol/L.

In a further embodiment, the concentration of molybdenum ions is 0.1 - 0.4 g/L, preferably 0.15 - 0.35 g/L.

The source of molybdenum ions may be one or more chemical compounds which comprise mo-lydenum and which deliver molybdenum containing ions so that molybdenum can be incorporated into the NiMoWP layer to be formed. Preferably, the source of molybdenum ions is sodiummolybdate dihydrate.

When the source of molybdenum ions is sodiummolybdate dihydrate, the concentration of sodiummolybdate dihydrate may be 0.25 - 1.00 g/L, preferably 0.38 - 0.88 g/L.

### The source of tungsten ions

In an embodiment, the concentration of tungsten ions is 12.1 - 109.2 mmol/L, preferably 24.2 - 97.1 mmol/L

In a further embodiment, the concentration of tungsten ions is 2.23 - 20.07 g/L, preferably 4.46 - 17.84 g/L.

The source of tungsten ions may be one or more chemical compounds which comprise tungsten and which deliver tungsten containing ions so that tungsten can be incorporated into the NiMoWP layer to be formed. For example, the source of tungsten ions is sodium tungstate dihydrate.

When the source of tungsten ions is sodium tungstate dihydrate the concentration of sodium tungstate dihydrate may be 4.0 - 36.0 g/L, preferably 8.0 - 32.0 g/L.

### The source of hypophosphite ions

Hypophosphite is used as reducing agent, for reducing nickel, molybdenum and tungsten.

The solution of the invention preferably does not comprise or contain any other reduction agent than hypophosphite. The solution of the invention preferably does not comprise any reducing agent comprising boron, particularly does not comprise dimethylamine borane (DMAB).

In an embodiment, the concentration of hypophosphite ions is 0.09 - 0.27 mol/L, preferably 0.11 - 0.23 mol/L.

In a further embodiment, the concentration of the hypophosphite ions is 5.85 - 17.55 g/L, preferably 7.15 - 14.95 g/L.

The source of hypophosphite ions may be one or more chemical compounds which comprise hypophosphite and which deliver phosphor to be incorporated into the NiMoWP layer to be formed. The source of hypophosphite ions may be hypophosphorous acid or a bath soluble salt thereof such as sodium hypophosphite, potassium hypophosphite and ammonium hypophosphite. For example, the source of hypophosphite ions is sodium hypophosphite.

When the source of hypophosphite ions is sodium hypophosphite, the concentration of sodium hypophosphite may be 10.0 - 30.0 g/L, preferably 12.7 - 26.3 g/L.

### The complexing agent

Following concentrations relate to the total amount of all complexing agents, if more than one complexing agent is used.

In an embodiment, the concentration of the complexing agent is 0.095 - 0.178 mol/L, preferably 0.109 - 0.164 mol/L.

The complexing agent may be a carboxylic acid. Useful carboxylic acids include the mono-, di-, tri- and tetra-carboxylic acids. The carboxylic acids may be substituted with various substituent moieties such as hydroxy or amino groups and the acids may be introduced into the plating solutions as their sodium, potassium or ammonium salts.

Examples of carboxylic acids which are useful as complexing agent in the solution of the present invention include: monocarboxylic acids such as acetic acid, hydroxyacetic acid (glycolic acid), aminoacetic acid (glycine), 2-amino propanoic acid, (alanine); 2-hydroxy propanoic acid (lactic acid); dicarboxylic acids such as succinic acid, amino succinic acid (aspartic acid), hydroxy succinic acid (malic acid), propanedioic acid (malonic acid), tartaric acid; tricarboxylic acids such as 2-hydroxy-1,2,3 propane tricarboxylic acid (citric acid); and tetracarboxylic acids such as ethylene diamine tetra acetic acid (EDTA). In one embodiment, mixtures of 2 or more of the above complexing/chelating agents are utilised in the solution of the invention.

The complexing agent may specifically be selected from the group consisting of citric acid, isocitric acid, EDTA, EDTMP, HDEP and Pyrophosphate.

The complexing agent may be a complexing agent suitable for alkaline pH.

In a specific embodiment, the complexing agent is citric acid.

When the complexing agent is citric acid, the concentration of citric acid may be 18.4 - 34.4 g/L (or 20.1 - 37.6 g/L in case of citric acid monohydrate), preferably 21.1 - 31.5 g/L (or 23.1 - 34.6 g/L in case of citric acid monohydrate).

### The organic sulphur containing compound

The organic sulphur containing compound, preferably a divalent sulphur containing compound, is used as a stabilizer for the plating solution. A stabilizer effectuates that no or less plating occurs in regions of the substrate where no plating is desired, e.g. on the passivation of a semiconductor substrate where no open area is provided. In addition it can increase bath stability to prevent the bath for its self-composition.

Following concentrations relate to the total amount of all sulphur containing compounds, if more than one sulphur containing compound is used.

In an embodiment, the organic sulphur containing compound is selected from the group consisting of N,N-dimethyl-dithiocarbamyl propyl sulfonic acid, 3-Mercaptopropane sulfonic acid, 3,3-Dithiobis-1-propane sulfonic acid, 3-(2-Benzthiazolylmercapto)propane sulfonic acid, 3-[(Ethoxy-thioxomethyl)thio]-1-propane sulfonic acid, 3-S-Isothiuroniumpropane sulfonate, sodium diethyl-dithiocarbamate, thiodiacetic acid, dithiodiacetic acid, thiodiglycolic acid, dithiodiglycolic acid, thiosulfate, thiourea, thiocyanate, cystein (if the amino acid in the plating solution is not cystein) or cystine.

The concentration of the organic sulphur containing compound is 0.38 - 38.00 µmol/L, preferably 1.9 - 19.0 µmol/L. Own experiments have shown that the given ranges within the scope of the present invention are best working. Higher and much higher concentration of organic sulphur containing compound are not well-working and lead to undesired results.

In a further embodiment, the organic sulphur containing compound comprises at least one sulphur atom having one or more free electron pairs, such as in a sulfide group. In a more specific embodiment, the concentration of the sulphur atoms having one or more free electron pairs is 0.38 - 38.00 µmol/L, preferably 1.9 - 19.0 µmol/L.

In a still more specific embodiment, the organic sulphur containing compound is N,N-dimethyl-dithiocarbamyl propyl sulfonic acid and the concentration is 0.1 - 10.0 mg/L, preferably 0.5 - 5.0 mg/L.

### The amino acid

Following concentrations relate to the total amount of all amino acids, if more than one amino acid is used.

The amino acid is used as a stress reducing additive. This means, that tensile stress in a plated layer is reduced.

In an embodiment, the amino acid a non-sulphur containing amino acid. Preferably the amino acid is selected from the group consisting of glycine and an amino acid having an unsubstituted carbohydrate side chain. In a specific embodiment, the amino acid is selected from the group consisting of glycine, alanine, valine, leucine or isoleucine.

In an embodiment, the concentration of the amino acid is 0.67 - 40.13 mmol/L, preferably 5.36 - 26.75 mmol/L.

In a more specific embodiment, the amino acid is glycine and the concentration is 0.05 - 3.00 g/L, preferably 0.4 - 2.0 g/L.

### Ratios of amino acid to organic sulphur containing compound

The following ratios are related to the total of all sulphur containing compounds and the total of all amino acids, if more than one of these is used.

In an embodiment, the molar ratio of amino acid to organic sulphur containing compound, preferably the ratio of amino acid to sulphur atoms having one or more free electron pairs, is from 282 : 1 - 14,079 : 1, more preferably within this preferred ratio the concentration of at least one organic sulphur containing compound is from 1.9 - 19.00 µmol/L and the concentration of the at least one amino acid is from 5.36 - 26.75 mmol/L.

In a specific embodiment, the amino acid is glycine and the organic sulphur containing compound is N,N-dimethyl-dithiocarbamyl propyl sulfonic acid and the molar ratio of glycine to N,N-dimethyl-dithiocarbamyl propyl sulfonic acid is 2,000 : 1 - 5,000 : 1.

### Optional ingredients of the solution

As a further ingredient, the solution may comprise an acid, such as sulphuric acid.

As a further ingredient, the solution may comprise a base, such as sodium hydroxide.

The solution may comprise one or more stabilizers, for example a source of Pb ions, Sn ions, Sb ions, Zn ions, Cd ions and/or Bi ions. Such stabilizers prevent spontaneous self-decomposition of the autocatalytic electroless nickel plating solution.

The source of Pb ions, Sn ions, Sb ions, Zn ions, Cd ions and/or Bi ions may be one or more chemical compounds which comprise one or more of these ions, and which delivers Pb ions, Sn ions, Sb ions, Zn ions, Cd ions and/or Bi ions. These ions can be conveniently introduced in the form of soluble and compatible salts such as the acetates, etc.

In one embodiment, the concentration of Pb ions Sn ions, Sb ions and/or Bi ions is 0.49 - 49.0 µmol/L, preferably 2.45 - 24.50 µmol/L. This concentration is related to the total of all Pb ions, Sn ions, Sb ions and/or Bi ions.

In a further embodiment, the concentration of Pb ions Sn ions, Sb ions and/or Bi ions is 0.1 - 10.0 mg/L, preferably 0.5 - 5.0 mg/L. This concentration is related to the total of all Pb ions, Sn ions, Sb ions and/or Bi ions.

In a specific embodiment, the source of lead ions is lead nitrate and the concentration of lead nitrate is 0.16 - 16.00 mg/L, preferably 0.8 - 8.00 mg/L.

Other materials may be included in the nickel plating solutions such as buffers, wetting agents, accelerators, inhibitors, brighteners, etc. These materials are known in the art.

### Further properties of the solution

The pH of the solution may be in the range of 7 - 11, preferably 8 - 10.

### The method of the invention

In the method of the invention, any solution of the invention which is described herein can be used.

The substrate is particularly a semiconductor chip or a semiconductor wafer. The substrate is converted into an article of the invention by plating a nickel alloy layer on the substrate. Thus, the substrate and the article distinguish by the nickel alloy layer of the invention. A wafer or chip may a substrate in the method and also an article of the invention, wherein both are distinguished by the nickel alloy layer. In other words, a wafer or chip is still called a wafer or chip, even if a nickel alloy layer of the invention or any further metal layer is added.

The method of the invention may be used to deposit a nickel layer on another metal, preferably on copper or aluminium. In a specific embodiment, the substrate comprises a copper layer or an aluminium layer, wherein the nickel alloy layer is plated on the copper layer or on the aluminium layer. The copper layer or the aluminium layer may extend over a whole surface or a part of a surface of the substrate.

In a specific embodiment, the substrate is a semiconductor wafer or chip, the wafer or chip comprising the copper layer or the aluminium layer.

In one embodiment, the method further comprises: plating a palladium layer on the nickel alloy layer. A palladium layer may be plated in order to obtain a bondable (solderable) surface.

In a further embodiment, the method further comprises: plating a gold layer on the palladium or on the nickel layer.

The method may involve the so-called "under bump metallisation" (UBM). UBM has been developed in view of recent demands for a wafer level miniaturisation, electrical signal integrity and metal stack reliability.

The UBM process can be generally separated into four different parts:
The first part involves pre-treatment and includes the surface preparation a surface of the mentioned copper or aluminium layer, for example a surface of Al/Al-alloy and Cu pads. For a pre-treatment of Al different zincations are available, for example Xenolyte™ cleaner ACA™, Xenolyte Etch MA™, Xenolyte CFA™ or Xenolyte CF™ (all available from Atotech Deutschland GmbH) which fulfil the industry standards of cyanide-free chemistry.

The second part in the UBM process involves electroless nickel plating.

Electroless plating of a nickel alloy layer can preferably be performed at a temperature of T = 40-90°C, more preferably 75-87°C. This temperature is the temperature of the solution of the invention.

The duration of contact of the solution of the invention with the substrate being plated is a function which is dependent on the desired thickness of the nickel alloy. Typically, the contact time can range from 1 to 30 minutes.

In the method of the invention, for plating of the nickel alloy layer on the substrate, the substrate is preferably immersed in the solution of the invention.

During the deposition of the nickel alloy, mild agitation may be employed, and this agitation may be a mild air agitation, mechanical agitation, bath circulation by pumping, rotation of a barrel plating, etc. The solution of the invention may also be subjected to a periodic or continuous filtration treatment to reduce the level of contaminants therein. Replenishment of the constituents of the bath may also be performed, in some embodiments, on a periodic or continuous basis to maintain the concentration of constituents, and in particular, the concentration of nickel ions and hypophosphite ions, as well as the pH level within the desired limits.

The third step of the UBM process comprises plating from an electroless palladium plating bath.

An electroless palladium bath is described e.g. in US5882736A. For Pd plating at lower temperatures, a step of activating the nickel alloy layer may optionally be carried out before the electroless Pd plating step.

Useful bath parameters for electroless Pd plating are as follows:
pH: preferred 5 to 6.5, more preferred 5.6 to 6.0
bath temperature: preferred 70 to 90 °C, more preferred 82 to 87 °C
Immersion time: preferred 3 to 20 min, more preferred 5 to 10 min
Additional stabilizer: preferred 10 to 500 mg/L, more preferred 100 to 300 mg/L.

If an activation step is carried out before the electroless Pd plating step, the Pd plating bath temperature may be as low as about 40 °C (and up to about 95 °C). Such activation may be achieved, for example by so-called ionogenic Pd activators which are usually acidic, contain a Pd²⁺ source such as PdCl₂ or PdSO₄ and deposit a seed layer of elemental Pd on the Ni-alloy layer. Such activators are well known to the skilled person and are commercially available as solutions under the trademark Xenolyte Activator ACU1™(product of Atotech Deutschland GmbH). So-called colloidal acidic activators, in which Pd clusters are surrounded by Sn, are equally well-known and may also be used.

The additional stabilizer in a state of the art electroless palladium bath as described in EP 0 698 130 may be used in order to deposit palladium without any additional activation on a nickel alloy layer of the invention. Furthermore, such stabilizers allow the electroless deposition of palladium at temperatures between 70 °C and 90 °C which leads to a reduced internal stress of the deposited palladium layer. Known electroless palladium baths show a short lifetime at such high bath temperatures which are not tolerable in industrial applications. The additional stabilizers are selected from the group comprising sulfimides, polyphenylsulfides, pyrimidines, polyalcohols and inorganic complexing agents like rhodanide. A preferred sulfimide is saccharine, preferred pyrimidines are nicotine amide, pyrimidine-3-suphonic acid, nicotinic acid, 2-hydroxy pyridine and nicotine. Preferred poly alcohols are polyethyleneglycol, polypropyleneglycol, polyeth-ylenglycol-polypropyleneglycol copolymers and derivatives thereof.

Finally, the optional gold layer may be plated on the Ni alloy/Pd stack. For this purpose, electroless gold plating electrolytes known from prior art can be used. The thickness of the optional gold layer on top of the palladium layer is 0.01 to 0.5 µm, preferably 0.05 to 0.3 µm. The optional gold layer is most preferably deposited by an immersion process. A suitable bath for electroless gold plating is available commercially under the trademark Aurotech SFplus™(T = 80 to 90 °C; pH = 4.5 to 6.0; immersion time = 7 to 15 min; 0.5 to 2 g/l Au (as K[Au(CN)2])

If an Al coated wafer is used in the present invention as a starting substrate, the process preferably comprises the steps of cleaning, etching, zincation (as pre-treatment steps), followed by nickel alloy plating, optionally activation of the nickel alloy layer, palladium plating and, optionally, gold plating.

If Cu coated wafers are used as the starting substrate, preferably an optional pre-treatment comprises the steps of cleaning, optionally etching, and Pd activation, optionally followed again by the steps of nickel plating, optionally activation of the nickel alloy layer, palladium plating and, optionally, gold plating.

### The nickel alloy layer and further products of the invention

The nickel alloy layer of the invention is obtainable or obtained from an electroless nickel plating solution as described above, when the solution is used for plating such layer, or by a method as described above.

The nickel alloy layer may be used as a barrier layer between two metal layers, for example between a copper layer and another metal layer, in order to prevent migration of copper into the other metal. The other metal is for example palladium or gold.

In one embodiment, the nickel alloy layer shows a normal stress in the range of -40 to +120 N/mm², preferably in the range of -20 to +40 N/mm². A normal stress with positive value is also called tensile stress. A normal stress with a negative value is also called compressive stress. The normal stress is measured by the Bent Strip Method: Deposition on Cu stress stripes (Copper-Iron Alloy PN: 1194) with subsequent stress determination by use of the Deposit Stress Analyzer ASTM Standard B975).

In an embodiment, the nickel alloy layer of the present invention has a thickness in the range of 0.1 - 5 µm, preferably 0.5 - 3 µm.

The article of the invention is obtained or obtainable by a method of the invention.

In one embodiment, the article of the invention comprises a copper layer or an aluminium layer, and the nickel alloy layer is disposed on the copper layer or on the aluminium layer.

Thus the article of the invention may comprise following layers:
copper layer or aluminium layer / nickel alloy layer (of the invention)
wherein the nickel alloy layer of the invention is preferably an outer layer, i.e. comprising a free, accessible surface.

The sign "/" means that the layers adjacent to this sign are in contact with each other, i.e. are neighboring layers.

The article of the invention may further comprise a palladium layer, wherein the palladium layer is disposed onto the nickel alloy layer. Thus, the article may comprise following stack of layers, in this order:
copper layer or aluminium layer / nickel alloy layer (of the invention)/ palladium layer
wherein the palladium layer is preferably an outer layer, i.e. comprising a free, accessible surface. A soldered connection may be made via the palladium layer to other devices, such as to a circuit carrier or a printed circuit board.

The nickel alloy layer may be used as a barrier layer between the copper layer and the palladium layer, in order to prevent migration of copper into palladium.

The article of the invention may further comprise a gold layer, wherein the gold layer is disposed direct on the nickel layer or onto the palladium layer. Thus, the article of the invention may comprise following stack of layers:
copper layer or aluminium layer / nickel alloy layer (of the invention)/ gold layer or copper layer or aluminium layer / nickel alloy layer (of the invention)/ palladium layer/ gold layer
wherein the gold layer is preferably an outer layer, i.e. comprising a free, accessible surface. A soldered connection may be made via the gold layer to other devices, such as to a circuit carrier or a printed circuit board.

Mentioned layers may extend over a whole surface or a part of a surface. For example, the copper layer may extend over a part of a surface or a whole surface of the substrate or article. The nickel alloy layer may extend over a part of a surface or a whole surface of the copper layer. The palladium layer may extend over a part of a surface or a whole surface of the nickel alloy layer. The gold layer may extend over a part of a surface or a whole surface of the palladium layer.

The article of the invention may further comprise a grid array of solder balls, also called ball grid array. The solder balls are preferably located on a surface of an above-mentioned palladium layer or on a surface of an above-mentioned gold layer.

### BRIEF DESCRIPTION OF THE FIGURES

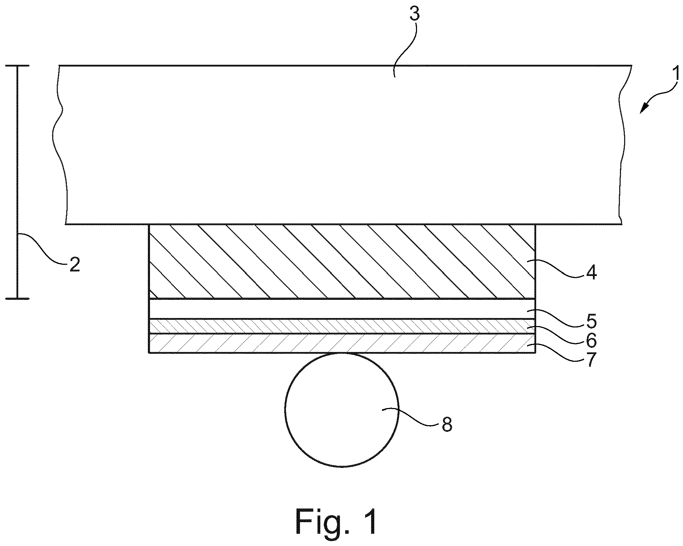

- Fig. 1: shows an article of the invention.

### EXAMPLES

### Methods

### Stress measurement

The normal stress is measured by the Bent Strip Method: Deposition on Cu stress stripes (Copper-Iron Alloy PN: 1194) with subsequent stress determination by use of the Deposit Stress Analyzer ASTM Standard B975).

### Fracture toughness

The indentation test was performed with a Fischerscope H100C using a Vickers. The nickel layer to be tested is annealed to a temperature of 400 °C during a period of 10 minutes (excluding heating-up and cooling-down). Then, a Vickers indenter (a specimen as used for determining Vickers hardness) is pressed into the layer with the maximum load of 1N, a holding time of 4 seconds and a loading/removal rate of dF/dt = +/-0.5 N/s. The indentations are then inspected by optical microscopy.

### Example 1: Composition of a plating solution of the invention

Following ingredients are mixed in water

| **Compound** | **Technical Function** | **Concentration in g/L** | **Concentration in mol/L** |
|---|---|---|---|
| | | | |
| NiSO₄ x 6 H₂O | Ni Source | 28.00 | 0.11 |
| Corresponding to Ni | | 6.4 | |
| (Sodium) hypophosphite x H₂O | Reducing agent | 18.2 | 0.16 |
| Citric Acid x H₂O (C₆H₈O₇ x H₂O) | Complexing agent | 28.8 | 0.14 |
| Sodium molybdate x 2 H₂O | Mo Source | 0.4 | 1.66 mmol/L |
| Corresponding to Mo | | 0.16 | |
| Sodium tungstate x 2 H₂O | W Source | 20.00 | 60.5 mmol/L |
| Corresponding to W | | 11.15 | |
| Sulphuric acid or sodium hydroxide | pH adjustor | In an amount to obtain a pH of 9.0 | |
| Lead nitrate | Stabilizer | 1.6 mg/L | 4.9 µmol/L |
| Corresponding to Pb | | 1.00 mg/L | |
| sulphur containing compound - Cystine | Organic Stabilizer | 1.0 mg/L | 3.8 µmol/L |
| amino acid (Glycine/Alanine) | Stress-reducing additive | 1.0 g/L | 13.3 mmol/L |

### Example 2: Layer composition

Example 2 shows the compositions of layers from six different depositions by using the solution of example 1. Plating time was 10 minutes for each deposition.

| | **Ni [wt%]** | **Mo [wt%]** | **W [wt%]** | **P [wt%]** |
|---|---|---|---|---|
| **1** | 89.71 | 4.94 | 1.79 | 2.60 |
| 2 | 89.96 | 5.12 | 1.86 | 2.37 |
| 3 | 90.67 | 5.59 | 1.08 | 1.82 |
| 4 | 89.38 | 6.98 | 1.19 | 2.18 |
| 5 | 91.36 | 5.29 | 0.56 | 1.65 |
| 6 | 89.13 | 6.33 | 1.34 | 2.43 |
| | | | | |
| Average wt% | 90.04 | 5.71 | 1.30 | 2.18 |
| Minimum wt% | 89.13 | 4.94 | 0.56 | 1.65 |
| Maximum wt% | 91.36 | 6.98 | 1.86 | 2.43 |
| | | | | |
| Average at% (atom percent) | 92.7 | 3.6 | 0.4 | 4.2 |
| Minimum at% | 91.7 | 3.1 | 0.2 | 3.2 |
| Maximum at% | 94.0 | 4.5 | 0.6 | 4.7 |

### Example 3: addition of reducing agent based on boron

Example 3 relates to comparative examples using all compounds of the solution of the invention but wherein the reduction agent Hypophosphite is mixed together with increasing amounts of DMAB (dimethylamine borane).

Following plating solution is used in Example 3: 2L Bath from Example 1, stirring at 250 rpm, 88°C. Plating time is reduced successively to obtain comparable Ni thicknesses.

Example 2a is an example according to the invention. Increasing amounts of DMAB are added to the plating solution indicated above, as further reducing agent (2c-e).

| **Sample** | **DMAB [g/L]** | **Plating Time [min]** | **Layer thickness Ni [µm]** | **Deflection U [-/+ -]** | **Material constants** | | **Stress [N/mm²]** |
|---|---|---|---|---|---|---|---|
| | | | | | **K Tens.[-]** | **K Comp.[-]** | |
| 2a | **0.0** | 10.00 | 1.385 | 4.0 | 0.2757 | 0.2416 | **46.5** |
| 2c | **1.0** | 3.50 | 1.282 | 20.0 | 0.2757 | 0.2416 | **251.0** |
| 2d | **2.0** | 2.50 | 1.113 | 21.0 | 0.2757 | 0.2416 | **303.5** |
| 2e | **3.0** | 2.50 | 1.055 | 21.0 | 0.2757 | 0.2416 | **320.3** |

With the experiment it is shown, that even if the combination and concentration of N,N-dimethyl-dithiocarbamyl propyl sulfonic acid and glycine in the solution of the invention is used in combination with DMAB, this will not lead to a stress reduction, in contrast to the present invention.

Addition of a boron based reducing agent deteriorates the stress properties of the layer drastically.

### Example 4: Variation of amino acid

Example 4 relates examples using a solution of the invention with different amounts of the amino acid alanine.

Following plating solution is used: Bath from Example 1, stirring at 250 rpm, 88°C but with following additive combination:

| | | | **Layer thickness** | **Deflection** | **Material constants** | | **Stress** |
|---|---|---|---|---|---|---|---|
| **Sample** | **Alanine [g/L]** | **Sodium Diethyl-dithiocarbamate [mg/L]** | **Ni [µm]** | **U [-/+ -]** | **K Tens.[-]** | **K Comp.[ -]** | **[N/m m²]** |
| 3a | **0,0** | 0,0 | 1,804 | 13,5 | 0,2757 | 0,2416 | 120,4 |
| 3b | **0,0** | 2,0 | 1,758 | 14,5 | 0,2757 | 0,2416 | 132,7 |
| 3c | **0,5** | 2,0 | 1,834 | 6,0 | 0,2757 | 0,2416 | **52,6** |
| 3d | **1,0** | 2,0 | 1,620 | 0,7 | 0,2757 | 0,2416 | **7,0** |
| 3e | **1,5** | 2,0 | 1,576 | -0,3 | 0,2757 | 0,2416 | **-2,7** |
| 3f | **2,5** | 2,0 | 1,456 | -1,5 | 0,2757 | 0,2416 | **-14,5** |
| 3g | **2,5** | 4,0 | 1,487 | -1,7 | 0,2757 | 0,2416 | **-16,1** |

Plating time is 8 min in all experiments. The experiments show that increasing amounts of alanine improves (lowers) the stress, and makes possible to reach the region of compressive stress (negative values) which may be beneficial because when the layer is heated, the stress increases and may result in a value of about zero or in the region around zero.

### Example 5: Variation of amounts of sulphur containing compound and amounts and amino acid glycine

Bath from Example 1, stirring at 250 rpm, 88°C, pH = 9.5, 10 minutes plating time but with following additive combination:

### 5.1 Combination of N,N-dimethyl-dithiocarbamyl propyl sulfonic acid and glycine

| N,N-dimethyl-dithiocarbamyl propyl sulfonic acid **in mg/L** | **Glycine in g/L** | **Ni Thickness in µm** | **Stress in U ± (+ tensile; - compress ive)** | **Stress in N/mm²** |
|---|---|---|---|---|
| 0 | 0.5 | 3.9 | 10 | 49.2 |
| 2.5 | 0 | 3.5 | 20 | 109.4 |
| 2.5 | 0.5 | 3.3 | -1.5 | -7.4 |

The first two experiments are comparative examples, the plating bath here only comprising one of N,N-dimethyl-dithiocarbamyl propyl sulfonic acid or glycine.

It is shown that the combination of both improves the stress properties of the layer in synergistic manner.

### 5.2 Combination of cystine and glycine

| **Cystine in mg/L** | **Glycine in g/L** | **Ni Thickness in µm** | **Stress in U ± (+ tensile; - compressive)** | **Stress in N/mm²** |
|---|---|---|---|---|
| 3 | 0 | 3.3 | 20 | 116 |
| 3 | 0.1 | 3.5 | 16.5 | 90 |
| 3 | 0.2 | 3.5 | 11.5 | 63 |
| 3 | 0.3 | 3.5 | 7.5 | 41 |
| 3 | 0.4 | 3.5 | 4.5 | 24 |
| 3 | 0.5 | 3.5 | 2.0 | 11 |
| 3 | 0.6 | 3.1 | -0.5 | -3 |
| 3 | 0.7 | 3.1 | -1 | -5 |
| 3 | 0.8 | 3.1 | -0.5 | -3 |
| 3 | 0.9 | 3.0 | -0.5 | -3 |
| 3 | 1.0 | 3.0 | -1.5 | -8 |
| 4 | 0.5 | 3.4 | -0.5 | -2 |
| 5 | 0.5 | 0.9 | 0 | 0 |
| 6 | 0.0 | 3.0 | 21 | 133 |
| 6 | 0.1 | 3.6 | 17.5 | 94 |
| 6 | 0.2 | 3.5 | 12 | 66 |
| 6 | 0.3 | 3.5 | 5.5 | 30 |
| 6 | 0.4 | 2.7 | 0 | 0 |
| 6 | 0.5 | 0.7 | -0.5 | -12 |

The two experiments without glycine are comparative examples.

It is shown that increasing amounts of glycine, at different amounts of cystine, improves the stress properties of the layer in synergistic manner.

### Example 6: Fracture toughness

### All samples have been annealed at 400 °C for 10 minutes.

| | **Comp. Ex. 1** | **Comp. Ex. 2** | **Comp. Ex. 3** | **Example 4** | **Example 5** | **Example 6** | **Example 7** | **Example 8** | **Example 9** |
|---|---|---|---|---|---|---|---|---|---|
| Thickness [µm] | 1.59 | 2.34 | 1.82 | 1.90 | 1.80 | 1.50 | 1.83 | 1.86 | 1.76 |
| P-content [wt.%] | 8.20 | 2.26 | 4.85 | 2.60 | 3.66 | 1.65 | 2.85 | 1.43 | 1.18 |
| Ni-content [wt.%] | 91.90 | 97.13 | 88.53 | 89.71 | 88.70 | 91.36 | 91.75 | 88.82 | 91.31 |
| W-content [wt.%] | - | - | 1.15 | 1.79 | 1.15 | 0.56 | 0.85 | 0.68 | 0,18 |
| Mo-content [wt.%] | - | - | 4.27 | 4.94 | 5.66 | 5.29 | 3.89 | 8.17 | 6.33 |
| Bath parameter | 84°C, pH 4.6 | 84°C, pH 7.3 | 88°C, pH 8.5 | 88°C, pH 8.5 | 88°C, pH 8.5 | 88°C, pH 8.5 | 88°C, pH 8.2 | 88°C, pH 8.8 | 88°C, pH 8.2 |
| Cracks in Fracture toughness test | Yes | Yes | Yes but less than in Comp. Ex. 1 and 2 | None | None | None | None | None | None |

Fracture toughness test is done as described in the methods above. Layers of the invention turn out to be significant more tough and show no cracking after indentation.

In comparative examples 1 and 2, Mo and W are missing wherein example 1 represents a common standard binary NiP layer with a medium P content of about 8.2 wt.%. This layer suffers from cracks after indentation. Example 2 is also a binary NiP layer and shows even the same P content like the layer of the invention but in contrast it shows cracks after indentation.

Comparative example 3 is a comparative example because the P content is higher than in the present invention.

Example 5 is an example with relatively high amount of phosphor, but in the range of the present invention.

Example 6 is an example with less phosphor in terms of the invention in the presence of relatively low amount of tungsten.

Example 7 is an example with medium P content in terms of the invention also in presence of both the low amounts of tungsten and molybdenum.

Fig. 1 shows (not true to scale) an electronic article 1 of the invention, comprising a nickel alloy layer 5. The nickel alloy layer 5 is produced by contacting a substrate 2, comprising a wafer 3 and the copper layer 4, with a plating solution of the invention.

When contacting the copper layer 4 of the substrate 2 with the plating solution of the invention, a nickel alloy layer 5 is plated on the copper layer 4. In a further method step, a palladium layer 6 is optionally plated on the nickel alloy layer 5.

In the shown stack of layers, the nickel alloy layer 5 serves as a barrier layer between the copper layer 4 and the palladium layer 6.

A gold layer 7 is optionally plated on the by palladium layer 6 and a solder ball 8 is placed on the gold layer 7 which is part of a ball grid array. Only a part of the wafer 3 is shown here. The wafer 3 comprises several layer stacks 4,5,6,7 at different positions, each layer stack comprising a solder ball 8). The wafer can comprise individual compartments of the wafer surface ("pads") and each compartment may comprise a layer stack 4,5,6,7 as shown here in one example.

## Claims

1. An electroless nickel plating solution, comprising
- a source of nickel ions,
- a source of molybdenum ions,
- a source of tungsten ions,
- a source of hypophosphite ions,
- at least one complexing agent,
wherein the solution does not comprise any reducing agent comprising boron,
**characterised in that** the solution further comprises
- at least one organic sulphur containing compound in a concentration of 0.38 - 38.00 µmol/L, and
- at least one amino acid in a concentration of 0.67 - 40.13 mmol/L.

2. The plating solution of claim 1, wherein the molar ratio of amino acid to organic sulphur containing compound is from 282 : 1 to 14,079 : 1.

3. The plating solution of one or more of the preceding claims, wherein a concentration of hypophosphite ions is 0.09 - 0.27 mol/L.

4. The plating solution of one or more of the preceding claims, wherein a concentration of nickel ions is 0.067 - 0.133 mol/L.

5. The plating solution of one or more of the preceding claims, wherein a concentration of molybdenum ions is 1.05 - 4.18 mmol/L.

6. The plating solution of one or more of the preceding claims, wherein a concentration of tungsten ions is 12.1 - 109.2 mmol/L.

7. The plating solution of one or more of the preceding claims, wherein the amino acid is a non-sulphur containing amino acid, preferably the amino acid is selected from the group consisting of glycine, alanine, valine, leucine and isoleucine.

8. The plating solution of one or more of the preceding claims, wherein the organic sulphur containing compound is selected from the group consisting of N,N-dimethyl-dithiocarbamyl propyl sulfonic acid, 3-Mercaptopropane sulfonic acid, 3,3-Dithiobis-1-propane sulfonic acid, 3-(2-Benzthiazolylmercapto)propane sulfonic acid, 3-[(Ethoxy-thioxomethyl)thio]-1-propane sulfonic acid, 3-S-Isothiuroniumpropane sulfonate, sodium diethlydithiocarbamate, thiodiacetic acid, dithiodiacetic acid, thiodiglycolic acid, dithiodiglycolic acid, thiosulfate, thiourea, thiocyanate, cystein and cystine.

9. The plating solution of one or more of the preceding claims, wherein the complexing agent is selected from the group consisting of citric acid, isocitric acid, EDTA, EDTMP, HDEP and Pyrophosphate.

10. A method for electroless plating of a nickel alloy layer (5) on a substrate (2), particularly a wafer (3), the method comprising contacting said substrate with an electroless nickel plating solution according to one or more of claims 1 - 9.

11. The method of claim 10, wherein the substrate comprises a copper layer (4) or aluminium layer, wherein the nickel alloy layer (5) is plated on the copper layer (4) or the aluminium layer.

12. A quaternary nickel alloy layer obtained from an electroless nickel plating solution of one or more of claims 1-9, comprising
- 81.5 to 98.4 wt% nickel
- 1 to 10 wt% molybdenum
- 0.1 to 4 wt% tungsten
- 0.5 to 4.5 wt% phosphor,
wherein the nickel alloy layer having a normal stress in the range of -40 to +120 N/mm², measured by following Bent Strip Method according to ASTM Standard B975: Deposition on Copper-Iron Alloy PN: 1194 stress stripes with subsequent stress determination by use of the Deposit Stress Analyzer.

13. An article (1), particularly a semiconductor chip or wafer, comprising a nickel alloy layer (5), wherein te nickel alloy layer is a nickel alloy layer according to claim 12 or a nickel alloy layer which is obtained according to a method of claim 10 or 11.

14. The article of claim 13, wherein the article comprises a stack of layers, in this order:
a copper layer or an aluminium layer followed by the nickel alloy layer and a palladium and/or gold layer, wherein the palladium layer is preferably an outer layer.

15. Use of the electroless nickel plating solution according to one or more of the claims 1-9 for producing a barrier layer according to claim 12 between two metal layers, in particular between a copper layer or an aluminium layer and a palladium or a gold layer.

## Patentansprüche

1. Galvanisierungslösung zum stromlosen Vernickeln, umfassend
- eine Quelle von Nickelionen,
- eine Quelle von Molybdänionen,
- eine Quelle von Wolframionen,
- eine Quelle von Hypophosphitionen,
- mindestens einen Komplexbildner,
wobei die Lösung kein Bor umfassendes Reduktionsmittel umfasst, **dadurch gekennzeichnet, dass** die Lösung ferner
- mindestens eine organische schwefelhaltige Verbindung in einer Konzentration von 0,38 - 38,00 µmol/L und
- mindestens eine Aminosäure in einer Konzentration von 0,67 - 40,13 mmol/L umfasst.

2. Galvanisierungslösung nach Anspruch 1, wobei das Molverhältnis von Aminosäure zu organischer schwefelhaltiger Verbindung 282:1 bis 14,079:1 beträgt.

3. Galvanisierungslösung nach einem oder mehreren der vorhergehenden Ansprüche, wobei eine Konzentration von Hypophosphitionen 0,09 - 0,27 mol/L beträgt.

4. Galvanisierungslösung nach einem oder mehreren der vorhergehenden Ansprüche, wobei eine Konzentration von Nickelionen 0,067 - 0,133 mol/L beträgt.

5. Galvanisierungslösung nach einem oder mehreren der vorhergehenden Ansprüche, wobei eine Konzentration von Molybdänionen 1,05 - 4,18 mmol/L beträgt.

6. Galvanisierungslösung nach einem oder mehreren der vorhergehenden Ansprüche, wobei eine Konzentration von Wolframionen 12,1 - 109,2 mmol/L beträgt.

7. Galvanisierungslösung nach einem oder mehreren der vorhergehenden Ansprüche, wobei die Aminosäure eine Aminosäure ist, die keinen Schwefel enthält, die Aminosäure vorzugsweise aus der Gruppe bestehend aus Glycin, Alanin, Valin, Leucin und Isoleucin ausgewählt ist.

8. Galvanisierungslösung nach einem oder mehreren der vorhergehenden Ansprüche, wobei die organische schwefelhaltige Verbindung aus der Gruppe bestehend aus N,N-Dimethyldithiocarbamylpropylsulfonsäure, 3-Mercaptopropansulfonsäure, 3,3-Dithiobis-1-propansulfonsäure, 3-(2-Benzthiazolylmercapto)propansulfonsäure, 3-[(Ethoxythioxomethyl)thio]-1-propansulfonsäure, 3-S-Isothiouroniumpropansulfonat, Natriumdiethyldithiocarbamat, Thiodiessigsäure, Dithiodiessigsäure, Thiodiglykolsäure, Dithiodiglykolsäure, Thiosulfat, Thioharnstoff, Thiocyanat, Cystein und Cystin ausgewählt ist.

9. Galvanisierungslösung nach einem oder mehreren der vorhergehenden Ansprüche, wobei der Komplexbildner aus der Gruppe bestehend aus Citronensäure, Isocitronensäure, EDTA, EDTMP, HDEP und Pyrophosphat ausgewählt ist.

10. Verfahren zum stromlosen Galvanisieren eines Substrats (2), insbesondere eines Wafers (3), mit einer Nickellegierungsschicht (5), das Verfahren umfassend das Inkontaktbringen des Substrats mit einer Galvanisierungslösung zum stromlosen Vernickeln gemäß einem oder mehreren der Ansprüche 1-9.

11. Verfahren nach Anspruch 10, wobei das Substrat eine Kupferschicht (4) oder Aluminiumschicht umfasst, wobei die Nickellegierungsschicht (5) auf die Kupferschicht (4) oder die Aluminiumschicht abgeschieden wird.

12. Quartäre Nickellegierungsschicht, erhalten aus einer Galvanisierungslösung zum stromlosen Vernickeln nach einem oder mehreren der Ansprüche 1-9, umfassend
- 81,5 bis 98,4 Gew.-% Nickel,
- 1 bis 10 Gew.-% Molybdän,
- 0,1 bis 4 Gew.-% Wolfram,
- 0,5 bis 4,5 Gew.-% Phosphor,
wobei die Nickellegierungsschicht eine Normalspannung im Bereich von -40 bis +120 N/mm² aufweist, die durch folgende Biegestreifenmethode (Bent Strip Method) gemäß der Norm ASTM B975 gemessen wird: Abscheidung auf Spannungsstreifen aus einer Kupfer-Eisen-Legierung PN:1194 mit anschließender Bestimmung der Spannung unter Verwendung der Analysevorrichtung zur Spannungsbestimmung in der Abscheidung (Deposit Stress Analyzer).

13. Gegenstand (1), insbesondere ein Halbleiterchip oder Wafer, umfassend eine Nickellegierungsschicht (5), wobei die Nickellegierungsschicht eine Nickellegierungsschicht gemäß Anspruch 12 oder eine gemäß einem Verfahren nach Anspruch 10 oder 11 erhaltene Nickellegierungsschicht ist.

14. Gegenstand nach Anspruch 13, wobei der Gegenstand einen Schichtstapel in dieser Reihenfolge umfasst: eine Kupferschicht oder eine Aluminiumschicht, gefolgt von der Nickellegierungsschicht und einer Palladium- und/oder Goldschicht, wobei die Palladiumschicht vorzugsweise eine Außenschicht ist.

15. Verwendung der Galvanisierungslösung zum stromlosen Vernickeln gemäß einem oder mehreren der Ansprüche 1-9 zur Herstellung einer Barriereschicht gemäß Anspruch 12 zwischen zwei Metallschichten, insbesondere zwischen einer Kupferschicht oder einer Aluminiumschicht und einer Palladium- oder einer Goldschicht.

## Revendications

1. Solution de placage de nickel autocatalytique, comprenant
- une source d'ions nickel,
- une source d'ions molybdène,
- une source d'ions tungstène,
- une source d'ions hypophosphite,
- au moins un agent complexant,
la solution ne comprenant aucun agent réducteur comprenant du bore, **caractérisée en ce que** la solution comprend en outre
- au moins un composé organique contenant du soufre en une concentration de 0,38 à 38,00 µmole/L, et
- au moins un acide aminé en une concentration de 0,67 à 40,13 mmole/L.

2. Solution de placage selon la revendication 1, le rapport molaire d'acide aminé sur composé organique contenant du soufre étant de 282 : 1 à 14 079 : 1.

3. Solution de placage selon l'une ou plusieurs des revendications précédentes, une concentration d'ions hypophosphite étant de 0,09 à 0,27 mole/L.

4. Solution de placage selon l'une ou plusieurs des revendications précédentes, une concentration d'ions nickel étant de 0,067 à 0,133 mole/L.

5. Solution de placage selon l'une ou plusieurs des revendications précédentes, une concentration d'ions molybdène étant de 1,05 à 4,18 mmole/L.

6. Solution de placage selon l'une ou plusieurs des revendications précédentes, une concentration d'ions tungstène étant de 12,1 à 109,2 mmole/L.

7. Solution de placage selon l'une ou plusieurs des revendications précédentes, l'acide aminé étant un acide aminé ne contenant pas de soufre, préférablement l'acide aminé étant choisi dans le groupe constitué par la glycine, l'alanine, la valine, la leucine et l'isoleucine.

8. Solution de placage selon l'une ou plusieurs des revendications précédentes, le composé organique contenant du soufre étant choisi dans le groupe constitué par l'acide N,N-diméthyl-dithiocarbamylpropylsulfonique, l'acide 3-mercaptopropanesulfonique, l'acide 3,3-dithiobis-1-propanesulfonique, l'acide 3-(2-benzothiazolylmercapto)propanesulfonique, l'acide 3-[(éthoxy-thioxométhyl)thio]-1-propanesulfonique, le sulfonate de 3-S-isothiuroniumpropane, le diéthyldithiocarbamate de sodium, l'acide thiodiacétique, l'acide dithiodiacétique, l'acide thiodiglycolique, l'acide dithiodiglycolique, un thiosulfate, la thiourée, un thiocyanate, la cystéine et la cystine.

9. Solution de placage selon l'une ou plusieurs des revendications précédentes, l'agent complexant étant choisi le groupe constitué par l'acide citrique, l'acide isocitrique, l'EDTA, l'EDTMP, le HDEP et un pyrophosphate.

10. Procédé pour le placage autocatalytique d'une couche (5) d'alliage de nickel sur un substrat (2), particulièrement une plaquette (3), le procédé comprenant la mise en contact dudit substrat avec une solution de placage de nickel autocatalytique selon l'une ou plusieurs des revendications 1 à 9.

11. Procédé selon la revendication 10, le substrat comprenant une couche (4) de cuivre ou une couche d'aluminium, la couche (5) d'alliage de nickel étant plaquée sur la couche (4) de cuivre ou la couche d'aluminium.

12. Couche d'alliage de nickel quaternaire obtenue à partir d'une solution de placage de nickel autocatalytique selon l'une ou plusieurs des revendications 1 à 9, comprenant
- 81,5 à 98,4 % en poids de nickel
- 1 à 10 % en poids de molybdène
- 0,1 à 4 % en poids de tungstène
- 0,5 à 4,5 % en poids de phosphore,
la couche d'alliage de nickel possédant une contrainte normale de -40 à +120 N/mm², mesurée en suivant le Procédé de la Bande Pliée selon la norme ASTM B975 : Dépôt d'Alliage Cuivre-Fer PN : 1194 bandes de contrainte avec détermination de contrainte subséquente par utilisation de l'Analyseur de Contrainte de Dépôt.

13. Article (1), particulièrement puce ou plaquette semi-conductrice, comprenant une couche (5) d'alliage de nickel, la couche d'alliage de nickel étant une couche d'alliage de nickel selon la revendication 12 ou une couche d'alliage de nickel qui est obtenu selon un procédé selon la revendication 10 ou 11.

14. Article selon la revendication 13, l'article comprenant un empilement de couches, dans cet ordre : une couche de cuivre ou une couche d'aluminium suivie par la couche d'alliage de nickel et une couche de palladium et/ou d'or, la couche de palladium étant préférablement une couche externe.

15. Utilisation de la solution de placage de nickel autocatalytique selon l'une ou plusieurs des revendications 1 à 9 pour la production d'une couche barrière selon la revendication 12 entre deux couches métalliques, en particulier entre une couche de cuivre ou une couche d'aluminium et une couche de palladium ou d'or.
